# EUROPÄISCHE PATENTSCHRIFT

(11) **EP 4 679 121 B1**
(45) Veröffentlichungstag und Bekanntmachung des Hinweises auf die Patenterteilung: **27.05.2026**
(21) Anmeldenummer: 25188219.7
(22) Anmeldetag: 08.07.2025
(51) Int. Cl.: G01R 33/30, B65G 51/02

(54) **NMR-APPARATUR MIT FLEXIBLER RÖHRE ZUM PROBENTRANSPORT**
NMR APPARATUS WITH FLEXIBLE TUBE FOR SAMPLE TRANSPORT
APPAREIL RMN AVEC TUBE FLEXIBLE POUR LE TRANSPORT D'ÉCHANTILLONS

(30) Priorität: 11.07.2024 DE 102024206558
(43) Veröffentlichungstag der Anmeldung: 14.01.2026
(73) Patentinhaber: Bruker Switzerland AG, 8117 Fällanden (CH)
(72) Erfinder: Schmid, Reto, 8409 Winterthur (CH); Sieber, Sven, 8607 Seegräben (CH)
(74) Vertreter: Kohler Schmid Möbus Patentanwälte

(56) Entgegenhaltungen:
- JP-A- 2006 234 539
- US-A- 5 150 054
- US-B2- 8 217 655

## Beschreibung

Die Erfindung betrifft eine Transporteinrichtung mit einer gasabgedichteten durchgehend bidirektional betreibbaren Transportröhre zur pneumatischen Beförderung von NMR-Messproben aus einem Proben-Speicher in ein Messvolumen innerhalb des NMR-Magnetsystems eines NMR-Spektrometers.

Eine solche Transporteinrichtung ist bekannt aus der US 5 150 054 A (=Referenz [0]).

NMR-Spektrometer mit derartigen Transporteinrichtungen sind bekannt aus der US 8,217,655 B2 (=Referenz [1]) oder auch aus der US 10,782,369 B2 (=Referenz [2]).

### Hintergrund der Erfindung

NMR-Spektrometer mit pneumatisch betriebenen Transporteinrichtungen werden bereits seit vielen Jahrzehnten von der Anmelderin hergestellt und vertrieben. Sie sind beispielsweise in der DE 37 29 819 C2 (=Referenz [3]) beschrieben.

Eine Transportvorrichtung zur pneumatischen Beförderung der NMR-Messproben ist bekannt aus der Firmenbroschüre "Bruker Sample Transport. BST Installation and Technical Manual Version 002" der Bruker BioSpin AG vom 21. November 2008 (=Referenz [4]), insbesondere aus den Kapiteln 2, 3 und 5.7 - 5.9 dieser Publikation. Im Folgenden wird eine derartige Transportvorrichtung mit "BST" abgekürzt.

Zur schnellen und exakten Analyse der chemischen Zusammensetzung von Messproben oder zur Strukturbestimmung von in den Proben enthaltenen Stoffen werden seit über einem halben Jahrhundert NMR-Verfahren eingesetzt. Diese können in NMR-Spektrometern durchgeführt werden. Für diese Zwecke geeignete NMR-Spektrometer sind beispielsweise auch in den oben zitierten Referenzen [1] bis [3] beschrieben.

Die NMR-Spektroskopie ist ein leistungsfähiges Verfahren der instrumentellen Analytik. Bei diesen NMR-Verfahren ist die Probe einem starken statischen Magnetfeld B₀ in einer z-Richtung ausgesetzt. Dabei kommt es zu einer Wechselwirkung mit den Kernspins des Probenmaterials, insbesondere zur Ausrichtung von Kernspins in der Messsubstanz. Sodann werden dazu orthogonale hochfrequente elektromagnetische Impulse in x- oder y-Richtung in die Probe eingestrahlt. Die zeitliche Entwicklung dieser Kernspins der Probe erzeugt wiederum hochfrequente elektromagnetische Felder, welche in der NMR-Apparatur detektiert werden. Aus den detektierten HF-Feldern können Informationen über die Eigenschaften der Probe integral über einen gewissen räumlichen Bereich erhalten werden. Insbesondere kann aus der Lage und Intensität von NMR-Linien auf die chemische Zusammensetzung sowie die chemischen Bindungsverhältnisse in der Probe geschlossen werden.

Die Messprobe umfasst in der Regel ein zylindrisches Probenröhrchen mit üblicherweise kreisrundem, ovalem oder rechteckigem Querschnitt, welches die feste oder flüssige Messsubstanz enthält. Das Probenröhrchen ist mindestens auf der Seite verschlossen, mit der es zuerst in den Probenkopf des NMR-Spektrometers eindringt, und befindet sich typischerweise in einem Transportbehälter, dem sogenannten Spinner. Probenröhrchen und Spinner mit der darin enthaltenden NMR-Messprobe werden mit Hilfe des Transportsystems von außerhalb des Magneten in den Probenkopf transportiert. Die oben zitierten Referenzen [1] bis [4] beschreiben eine Transportvorrichtungen zum Befördern einer solchen NMR-Messprobe zwischen einem Eingabepunkt, an dem es in die Transportvorrichtung eingesetzt und entnommen werden kann, und einem Zuführungspunkt, an dem das Probenröhrchen -im Falle eines NMR-Spektrometers mit supraleitendem Magnetsystem- einem Raumtemperatur-Rohr eines Kryostaten zugeführt werden kann, wobei der Eingabepunkt zum Zuführungspunkt sowohl horizontal als auch vertikal beabstandet ist, und wobei ein rohrförmiger Transportkanal zum pneumatischen Befördern des Probenröhrchens von einem ersten Transferpunkt am oberen Ende des Transportrohrs zu einem zweiten Transferpunkt an dessen unterem Ende vorgesehen ist.

Im Folgenden wird davon ausgegangen, dass sich die Einführungsöffnung oben am Probenkopf des NMR-Spektrometers befindet und die NMR-Messprobe also von oben in den Probenkopf eingeführt wird. Es ist jedoch auch denkbar, das Probenröhrchen von unten in eine dafür vorgesehene Öffnung in den Probenkopf einzuführen. Dieser Fall ist analog zum oben genannten und soll aus Gründen der Übersichtlichkeit hier nicht näher beschrieben werden. Wenn die NMR-Messprobe in der Messposition angekommen ist, befindet sich der Spinner innerhalb einer Turbine. Diese Turbine ermöglicht eine Rotation des Probenröhrchens (siehe etwa US 9,726,735 B2 = Referenz [5]).

Die US 9,903,923 B2 (=Referenz [6]) zeigt eine Transporteinrichtung zum Transport einer NMR-Probe zum Probenkopf eines NMR-Spektrometers. Die Transporteinrichtung weist einen Transportbehälter für die Probe mit einer speziell modifizierten Verriegelungsvorrichtung auf. Der Transportbehälter ist so ausgelegt, dass er sowohl für den Transport eines HR-NMR Sample Spinners mit eingelegtem Probenröhrchen als auch eines NMR MAS-Rotors einsetzbar ist. Auf diese Weise kann ohne Umbauten des Transportsystems nur durch Auswechseln des Probenkopfes rasch zwischen NMR-Spektroskopie von Flüssigkeiten zu Festkörpern und umgekehrt gewechselt werden.

Generell sollte die Tot-Zeit zwischen zwei aufeinanderfolgenden Messungen im NMR-System möglichst kurz sein. Die NMR-Messproben sollten daher möglichst schnell gewechselt werden können. Ein geeignetes automatisierbares, kompaktes Schnellwechselsystem mit einer Sensoreinrichtung zur Erkennung eines Transportbehälters sowie mit speziellen Parkaufnahmen zum zeitweiligen Zwischenspeichern eines im Spektrometer ankommenden Transportbehälters wird in US 11,073,583 B2 (=Referenz [7]) vorgeschlagen.

Die JP 2006-234539 A (=Referenz [8]) zeigt eine NMR-Apparatur mit einem supraleitenden NMR-Magnetsystem in einem Kryostaten, welcher von der Umgebung mechanisch entkoppelt ist, um Vibrationen zu minimieren. Die Probenzuführung in das NMR-Messvolumen erfolgt über eine Trichter-förmige Anordnung. Die NMR-Messproben werden dabei aus einem Reservoir räumlich außerhalb der Vibrationsentkopplung entnommen, die neben der eigentlichen NMR-Apparatur angeordnet ist, und dann über einen Luftspalt in eine starr mit der NMR-Apparatur verbundene Transporteinrichtung zum NMR-Messvolumen befördert. Ein etwaiger Versatz zwischen dem Reservoir und dem Kryostaten wird mit einer Sensorik aktiv überwacht. Nachteilig an dieser Vorrichtung ist, dass die Transporteinrichtung fest mit der NMR-Apparatur verbunden ist und beim Transport einer NMR-Messprobe Vibrationen auf diese überträgt.

Eine ähnliche NMR-Apparatur zeigt die US 11,231,471 B2 (=Referenz [9]), bei welcher ebenfalls eine Trichter-förmige Anordnung NMR-Messproben aus einem außerhalb der Vibrationsentkopplung der eigentlichen NMR-Apparatur positionierten Reservoir entgegennimmt. Ein pneumatischer Transport der NMR-Messproben in den Kryostaten der NMR-Apparatur ist hier nicht vorgesehen.

In der US 2015/0198681 A1 (=Referenz [10]) ist wiederum eine NMR-Apparatur mit Kryostat beschrieben. Über ein starres vertikales Transportrohr werden hier NMR-Messproben pneumatisch aus einem Proben-Speicher, welcher mechanisch *nicht* vom Kryostaten beziehungsweise dem NMR-Magnetsystem entkoppelt ist, zu einem Aufnahmepunkt über dem Kryostaten befördert.

Die US 2024/0069129 A1 (=Referenz [11]) zeigt ebenfalls ein NMR-Spektrometer, bei welchem NMR-Messproben durch eine starre Röhre pneumatisch in die Messregion befördert werden. Über eine mechanische Entkopplung der NMR-Apparatur von der Umgebung werden jedoch keine Angaben gemacht.

In der eingangs zitierten Referenz [1] werden NMR-Messproben pneumatisch über ein starres Transportrohr in das Messvolumen innerhalb eines das NMR-Magnetsystem enthaltenden Kryostaten befördert, wobei letzterer Vibrationsentkoppelt von seiner Umgebung aufgestellt ist. Der Proben-Speicher ist hier nicht vom Kryostaten mechanisch entkoppelt, sondern starr mit diesem verbunden. Die NMR-Apparatur nach Referenz [2] zeigt einen ähnlichen Aufbau ohne mechanische Entkopplung des Proben-Speichers vom NMR-Magnetsystem, wobei in Referenz [2] ein Doppelrohrsystem zur besseren Steuerung der Position des Transportgutes eingesetzt wird. Wie oben bereits angesprochen werden die Kryostaten von NMR-Systemen zum Zwecke der Vibrationsminimierung in der Regel durch pneumatische Dämpfer mechanisch von Gebäudeschwingungen entkoppelt. Dadurch wird jedoch grundsätzlich der automatische Transport von zu messenden NMR-Proben erschwert.

Die aktuell von der Anmelderin vertriebene Lösung mit einem starren, pneumatischen Transportrohr bedingt eine -starre- mechanische Koppelung des Proben-Speichers an die NMR-Apparatur, insbesondere an den Kryostaten bei Verwendung supraleitfähiger Magnetsysteme. Dadurch sind die Größe, das Gewicht und die Bauform des Proben-Speichers stark eingeschränkt. Die Bewegung der NMR-Messproben im Probenspeicher während einer NMR-Messung kann letztere empfindlich stören.

Soll die NMR-Messprobe an einen mechanisch entkoppelten Roboter weiter transportiert werden, so muss dieser Roboter bei den NMR-Apparaturen nach dem Stand der Technik zumindest einen mechanischen Versatz ausgleichen können.

### Aufgabe der Erfindung

Der vorliegenden Erfindung liegt demgegenüber die Aufgabe zugrunde, ein NMR-Spektrometer mit einer Transporteinrichtung der eingangs definierten Art mit möglichst einfachen technischen Maßnahmen so zu modifizieren, dass die oben aufgezählten Nachteile vollständig oder zumindest weitestgehend vermieden werden, ohne damit eine Minderung der Qualität der NMR-Messungen hervorzurufen, wobei die NMR-Apparatur besonders kompakt bleiben soll und etwaige zusätzliche Materialkosten sowie weiterer Fertigungsaufwand unerheblich bleiben.

Insbesondere soll die Erfindung eine passive mechanische Abkopplung vom Vibrations-entkoppelten NMR-Magnetsystem ermöglichen, ohne dass während des Betriebs der Transporteinrichtung eine aktive Überwachung der Position des NMR-Magnetsystems relativ zum Probenspeicher durch Sensoren und eine Nachsteuerung eines eventuellen Versatzes durch Aktoren erforderlich ist. Schließlich soll die erfindungsgemäße Änderung der bekannten Transporteinrichtung dahingehend konzipiert sein, dass sie ohne größere Umbauten optimal auch für vorhandene Systeme nach dem Stand der Technik einsetzbar ist, etwa für den "*SampleJet*" und den "*SampleCase*" der Anmelderin.

### Kurze Beschreibung der Erfindung

Diese relativ komplexe Aufgabe wird auf ebenso überraschend einfache wie wirkungsvolle Weise dadurch gelöst, dass eine gattungsgemäße Transportröhre trotz Gasabdichtung mechanisch flexibel aus einer Vielzahl von miteinander verbundenen, gegeneinander beweglich angeordneten, in Bezug auf den Strömungsquerschnitt der Transportröhre dimensionsstabilen Teilgliedern in Form von für sich jeweils starren Rohrabschnitten aufgebaut ist, derart, dass auch bei einer axialen Verschiebung oder einer Verkippung unmittelbar benachbarter Teilglieder gegeneinander radial innere Abschnitte der hohlen Teilglieder, insbesondere radial innere Kanten, nicht in den lichten Strömungsquerschnitt im Inneren der Transportröhre ragen, durch welchen die NMR-Messproben pneumatisch befördert werden sollen.

Auf diese Weise wird sichergestellt, dass die NMR-Messproben bei ihrem Transport durch die Röhre nicht an derartigen Hindernissen hängen bleiben oder sich verfangen können. Dennoch erlauben die Übergänge eine definierte Beweglichkeit benachbarter Teilglieder gegeneinander. Diese sind radial exakt aufeinander ausgerichtet.

Die bewegliche, mechanisch flexible Röhre ist aus verschiedenen Teilglieder (Stücke) zusammengesetzt. Die Übergänge dieser Teilglieder sind so konstruiert, dass sie Gas- bzw. Luft-abgedichtet sind, um die zu transportierende NMR-Messprobe pneumatisch zu bewegen. Die flexible Röhre erlaubt einen Transport durch pneumatischen Unter- oder Überdruck. Eine absolute Dichtheit -wie etwa bei Vakuum-Systemen- ist hierzu allerdings nicht unbedingt erforderlich.

Die erfindungsgemäß gestaltete flexible Transportröhre kann mechanischen Versatz zu einem Proben-Speicher kompensieren, ohne dabei das Transportgut (NMR-Messprobe) etwa von außen zugänglich zu machen, was ansonsten eine Gefährdung für Benutzer der NMR-Apparatur darstellen würde.

Die vorliegende Erfindung ermöglicht es, durch ihre flexible Bauart die normalerweise bei Anordnungen nach dem Stand der Technik immer vorhandene Aktions-Schwelle vom festen Gebäude zum gedämpften, beweglichen NMR-Magnetsystem (bzw. dem Kryostaten supraleitenden NMR-Magneten) ohne größeren Aufwand zu überwinden. Dadurch wird eine passive, mechanische Bewegungs- und Vibrations-Entkoppelung des Proben-Speichers vom NMR-Magnetsystem erreicht.

Dies macht unter anderem auch die Gestaltung ganz neuer NMR-Automationslösungen möglich.

Insgesamt kann damit ein sehr robuster, schonender und trotzdem besonders schneller Transport der NMR-Messprobe ohne die Notwendigkeit einer besonderen sensorischen Überwachung und Regelung der relativen Bewegungen zwischen Proben-Speicher und NMR-Magnetsystem erreicht werden.

Da die erfindungsgemäße Transporteinrichtung eine lediglich *passive* Vibrationsentkopplung ermöglicht und keine aktiven Überwachungs- und Nachsteuer-Funktionen erforderlich macht, kommt es im Betrieb auch zu deutlich weniger Störungen und es müssen keine besonderen Wartungsmaßnahmen vorgeschrieben werden.

Gerade aufgrund der durch die Erfindung eröffneten Möglichkeiten einer verbesserten automatisierten Schnellzuführung von -idealerweise vielleicht sogar schon vortemperierten- NMR-Messproben wird es ermöglicht, den NMR-Messzyklus sehr kurz zu halten. Durch diese zeitliche Verkürzung des Messzyklus ergeben sich hohe wirtschaftliche Vorteile, wenn mehr Messungen in der gleichen Zeit durchgeführt werden können.

An dieser Stelle sei ausdrücklich darauf hingewiesen, dass sich die Vorteile der Erfindung nicht nur bei vertikalen NMR-Spektrometern, sondern ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Magnetspulensystems liegen, sondern gegebenenfalls auch "rechts" oder "links" neben demselben. Jedenfalls spielt die Schwerkraft bei der Wirkungsweise der vorliegenden Erfindung, wenn überhaupt, dann lediglich eine untergeordnete Rolle.

### Bevorzugte Ausführungsformen der Erfindung

In den Rahmen der vorliegenden Erfindung fällt auch ein NMR-Spektrometer mit einem NMR-Magnetsystem, das auf einer Einrichtung zur Vibrations-Entkoppelung des NMR-Magnetsystems von der Umgebung aufgebaut ist, mit einem Proben-Speicher zur Bereitstellung und Zwischenlagerung einer Vielzahl von zu vermessenden NMR-Messproben sowie mit einer Transporteinrichtung der oben beschriebenen erfindungsgemäßen Art zur Beförderung jeweils einer NMR- Messprobe aus dem Proben-Speicher in ein Messvolumen innerhalb des NMR-Magnetsystems.

Bei einer Klasse von besonders vorteilhaften Ausführungsformen der Erfindung weisen die Teilglieder der Transportröhre an ihrem jeweiligen Endabschnitt, mit dem sie zu einem unmittelbar benachbarten Teilglied anschließen, entweder die Form eines positiven oder eines negativen Kugelgelenksegments auf. Das jeweilige positive Kugelgelenksegment greift passgenau in das negative Kugelgelenksegment des benachbarten Teilglieds derart ein, dass die betreffenden beiden Kugelgelenksegmente flächig aneinander anliegen und eine ausreichende Abdichtfunktion zwischen dem lichten Strömungsquerschnitt der Transportröhre und ihrer Außenseite im Übergangsbereich der beiden Kugelgelenksegmente ausüben.

Diese Funktionen werden dadurch erreicht, indem die Luftdichtheit und die Übergangskanten-Freiheit auf verschiedenen radialen Abständen von der Achse eines jeden Teilglieds gelöst werden. Auf einem äußeren Radius sorgt ein Kugelgelenk dafür, dass sich die Glieder bewegen können, ohne dass das für den Transport verwendete Gas (in der Regel Luft) entweichen kann.

Durch einfache Umgestaltung des Kugelgelenkes in eine verschiebbare Führung kann die Beweglichkeit auch eine Längen- Ausdehnung der Übergänge zulassen. Damit lässt sich auf einfache Weise und technisch unaufwändig die erforderliche definierte Beweglichkeit benachbarter Teilglieder gegeneinander bewirken.

Bei vorteilhaften Varianten dieser Weiterbildungen sind zusätzlich zu den positiven oder negativen Kugelgelenksegmenten an den Endabschnitten der Teilglieder, mit denen sie zu unmittelbar benachbarten Teilgliedern anschließen, auch zylindrische Teilflächen vorhanden, die vorzugsweise Teil insbesondere der negativen Kugelgelenksegmente sind.

Damit können auch Axialbewegungen der Teilglieder gegeneinander stattfinden. Eine weiterhin vorteilhafte Weiterbildung umfasst einseitige konische Teilflächen in den Übergangsbereichen der Teilglieder, die bei Eingriff in eine zylindrische Gegenfläche im benachbarten Teilglied eine Verkippung der Teilglieder gegeneinander beschränkt.

Ganz besonders bevorzugt sind Ausführungsformen der erfindungsgemäßen Transporteinrichtung, bei welchen die Teilglieder in einem inneren Bereich der Übergänge zwischen benachbarten Teilgliedern eine ineinandergreifende Zahnstruktur aufweisen, deren eine Außenfläche konisch geformt ist. Auf einem inneren Radius sorgt diese dem Transportgut angepasste Verzahnung dafür, dass keine axialen Kanten entstehen.

Die Verzahnung sollte so ausgelegt sein, dass der Druck unter der NMR-Messprobe nicht absinkt, indem die Höhe der Zähne nicht größer ist als die abdichtende Führungslänge des Transportgutes.

Weiterhin verhindert die Zahnstruktur eine Verdrehung benachbarter Teilglieder gegeneinander, was beim Anbringen von Leitungen außen an die Transportröhre vorteilhaft ist.

Weitere bevorzugte Ausführungsformen der Erfindung zeichnen sich dadurch aus, dass die Transportröhre im Bereich der Übergänge zwischen benachbarten Teilgliedern derart ausgestaltet ist, dass aufgrund der Geometrie der jeweiligen Teilglieder der Grad der möglichen relativen Winkelbewegung zwischen den beiden benachbarten Teilgliedern eingeschränkt ist, sodass ein vorgebbarer minimaler Krümmungsradius der Transportröhre nicht unterschritten werden kann, was das Transportgut ansonsten blockieren könnte. Insbesondere liegt die maximale Verkippung benachbarter Teilglieder (16') zwischen 0,1° und 5°, besonders bevorzugt bei 0,5°.

Weitere vorteilhafte Ausführungsformen der Erfindung sind dadurch gekennzeichnet, dass die Transportröhre im Bereich der Übergänge zwischen benachbarten Teilgliedern durch eine zylindrische Kupplung mit einandergreifenden Zylinderflächen, welche eine axiale Verschiebung ermöglicht, derart ausgestaltet ist, dass auch LängenAusdehnungen in Längsrichtung der Transportröhre kompensiert werden können.

Da sich das NMR-Magnetsystem auf den Dämpfungselementen der Einrichtung zur Vibrations-Entkoppelung in vertikaler Richtung bewegen kann, ist die Möglichkeit einer derartigen Längsausdehnung der Transportröhre von Nutzen.

Bevorzugt ist auch eine Ausführungsform der erfindungsgemäßen Transporteinrichtung, bei der zumindest einige der Teilglieder der Transportröhre baugleich gestaltet sind.

Dies ermöglicht unter anderem eine besonders kostengünstige, aber dennoch hochgenaue und insbesondere geometrisch äußerst präzise Herstellung der einzelnen Teilglieder. In der Regel werden nämlich die Teilglieder relativ enge Fertigungstoleranzen bedingen, um die Funktion (Dichtheit, Beweglichkeit, Passform) reproduzierbar zu gewährleisten. Außerdem können die einzelnen Teilglieder der flexiblen Transportröhre mitunter komplexe Bauformen aufweisen, welche dann nur bedingt konventionell (etwa spanabhebend) hergestellt werden können.

Des Weiteren ist auch eine Klasse von Ausführungsformen der Erfindung von Vorteil, bei welchen die Transportröhre Teilglieder unterschiedlicher Länge und/oder unterschiedlicher Bewegungsfreiheit enthält, um das Biegeverhalten entlang der Transportröhre zu verändern.

Die erfindungsgemäße flexible Röhre kann auch mit bereits vorhandenen, in einer bestehenden NMR-Apparatur eingesetzten starren Transportröhren kombiniert werden, um vereinfacht längere Distanzen zu überbrücken. Anfangs- und End-Positionen der flexiblen Transportröhre bedingen Teilglieder mit einer gesonderten Bauform (insbesondere ohne die spezielle, bewegliche Schnittstelle), um das Transportgut in starre Systemkomponenten übergeben zu können.

Die flexible Transportröhre kann so ausgestaltet werden, dass die einzelnen Glieder wahlweise in einer definierten oder undefinierten Dreh-Orientierung zusammengesetzt werden können.

Bei weiteren Ausführungsformen ist die erfindungsgemäße Transporteinrichtung so ausgestaltet, dass im Übergangsbereich zwischen unmittelbar benachbarten Teilgliedern der Transportröhre Dichtmittel angeordnet sind, insbesondere flexible Dichtmasse oder O-Ringe.

In der Praxis dürften sich Ausführungsformen bewähren, bei welchen die Teilgliedern der Transportröhre so gestaltet sind, dass die Transportröhre ohne Werkzeug wiederholbar zerlegt und wieder zusammengesetzt werden kann, insbesondere zum Transport, zur Wartung, Reparatur und Reinigung und/oder zur Längenanpassung der Transportröhre. Dies lässt sich beispielsweise dadurch erreichen, dass die Teilglieder zumindest im Übergangsbereich aus einem elastischen Material, insbesondere Kunststoff, aufgebaut sind, sodass sie sich beim Aneinanderfügen oder Trennen elastisch verformen und daher auch ohne Werkzeug leicht montiert oder demontiert werden können.

Insbesondere kann die flexible Transportröhre für eine Lieferung zum Anwender der NMR-Apparatur zerlegt werden. Somit entfallen unhandlich große Verpackungen für lange Rohre.

Vorteilhaft sind auch Ausführungsformen der erfindungsgemäßen Transporteinrichtung, bei denen zumindest einige Teilglieder der Transportröhre verschließbare radiale Öffnungen aufweisen, um den pneumatischen Gasstrom zu steuern und damit das pneumatische Transportverhalten entlang der Transportröhre beeinflussen zu können.

Es kann beispielsweise wünschenswert sein, die Geschwindigkeit der NMR-Messprobe vor dem Eintritt in den NMR-Probenkopf zu verringern und daher in diesem Abschnitt die radialen Öffnungen offen zu lassen.

Je nach speziellem Einsatzzweck können Ausführungsformen der erfindungsgemäßen Transporteinrichtung von besonders hohem Nutzen sein, bei denen zumindest einige Teilglieder der Transportröhre ganz oder teilweise aus optisch transparentem Material aufgebaut sind, damit die NMR-Messprobe auf ihrem Weg vom Proben-Speicher zum Messvolumen und wieder zurück zumindest stellenweise von außen sichtbar bleibt.

Ebenso kann es von Vorteil sein, wenn bei Ausführungsformen der erfindungsgemäßen Transporteinrichtung die Transportröhre aus elektrisch leitfähigem Material aufgebaut oder mit einem solchen beschichtet ist, um elektrostatische Aufladungen zu verhindern.

Möglich sind auch Ausführungsformen, bei welchen zumindest einige Teilglieder der Transportröhre als Schlauchabschnitte, vorzugsweise mit interner und/oder externer Stützstruktur, ausgeführt sind, um den definierten Innendurchmesser auch an gebogenen Stellen zu gewährleisten. Die Schlauchabschnitte und die Stützstruktur sind derart beschaffen, dass die Teilglieder der Transportröhre für sich jeweils starr sind.

Die Transportröhre der erfindungsgemäßen Transporteinrichtung kann bei vorteilhaften Ausführungsformen an ihrer radialen Außenseite eine Kabel- und/oder Schlauchführung aufweisen.

Besonders bevorzugt schließlich ist eine Klasse von Ausführungsformen der erfindungsgemäßen Transporteinrichtung, die sich dadurch auszeichnen, dass die Transportröhre Befestigungselemente zur Befestigung an Teilen des NMR-Spektrometers und/oder zum parallelen Ankoppeln mehrerer Transportröhren aneinander aufweist.

Damit können einzelne Elemente mit anderen Teilen der Mechanik des NMR-Spektrometers verbunden und/oder mehrere flexible Röhren parallel aneinander gekoppelt werden.

Weitere Vorteile der Erfindung ergeben sich aus der Beschreibung und der Zeichnung. Ebenso können die vorstehend genannten und die noch weiterausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematisierte, teilweise transparente seitliche Vertikalschnitt-Ansicht auf eine Ausführungsform des NMR-Spektrometers gemäß der vorliegenden Erfindung mit einer erfindungsgemäß modifizierten Transporteinrichtung;
- Fig. 2a: eine schematische Vertikalschnitt-Ansicht einer Ausführungsform der erfindungsgemäßen Transporteinrichtung mit drei zusammengefügten Teilgliedern sowie einer darin durch einen Gasstrom bewegten NMR-Messprobe;
- Fig. 2b: eine vergrößerte Detail-Darstellung des unteren Endes des untersten Teilglieds der Transporteinrichtung von Fig. 2a;
- Fig. 3: eine teil-transparente schematische räumliche Ansicht einer Ausführungsform eines Teilgliedes der erfindungsgemäß modifizierten Transporteinrichtung; und
- Fign. 4a bis 4d: vier schematische Vertikalschnitt-Ansichten unterschiedlicher Aspekte der Gestaltung des Überlappungsbereichs der Teilglieder.

Generell befasst sich die vorliegende Erfindung mit einer modifizierten Transporteinrichtung von NMR-Messproben zu und von einem **NMR-Spektrometer 10.** Die Vorteile der Erfindung können aber auch bei einem Spektrometer mit anderer physikalischer Messtechnik genutzt werden, wobei dann womöglich entsprechende geeignete Modifikationen vorgenommen werden müssen.

Das NMR-Spektrometer 10 ist ausgestattet mit einem **NMR-Magnetsystem 11,** das auf einer **Einrichtung 12 zur Vibrations-Entkoppelung** des NMR-Magnetsystems von der Umgebung aufgebaut ist, mit einem **Proben-Speicher 13** zur Bereitstellung und Zwischenlagerung von zu vermessenden **NMR-Messproben 14** sowie mit der Transporteinrichtung zur Beförderung jeweils einer NMR- Messprobe 14 aus dem Proben-Speicher 13 in ein **Messvolumen 15** innerhalb des NMR-Magnetsystems 11, wobei die Transporteinrichtung eine durchgehende, pneumatisch bidirektional betreibbare, gasabgedichtete **Transportröhre 16** umfasst.

In der Regel ist auch eine Vorrichtung zur Erzeugung von Überdruck beziehungsweise Unterdruck in dem NMR-Spektrometer-abgewandten Ende des rohrförmigen Transportkanals vorgesehen, die jedoch in der Zeichnung der Übersichtlichkeit halber nicht dargestellt ist.

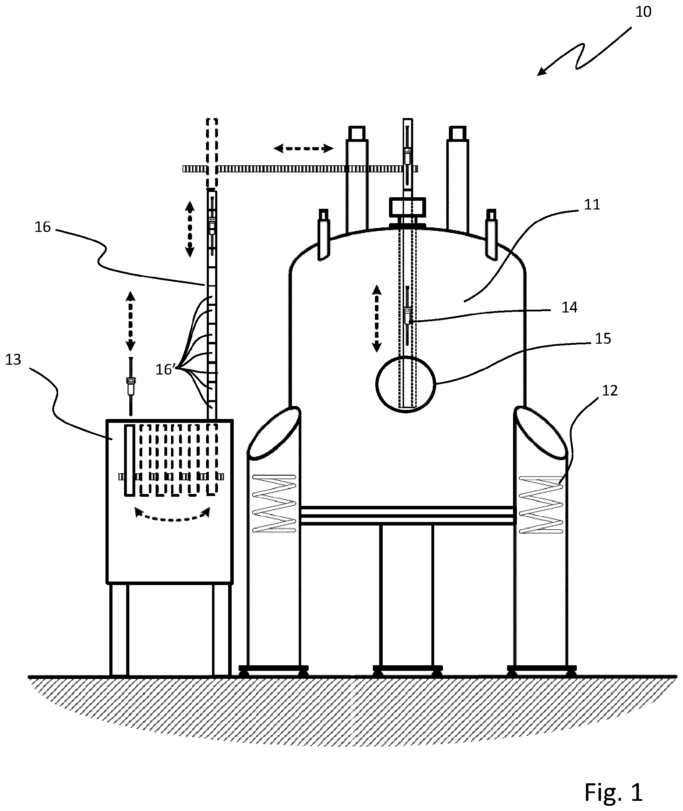

Wie bei dem in **Fig. 1** dargestellten Ausführungsbeispiel der Erfindung angedeutet, zeichnen sich das erfindungsgemäße NMR-Spektrometer 10 sowie dessen Transporteinrichtung dadurch aus, dass die Transportröhre 16 trotz Gasabdichtung mechanisch flexibel -insbesondere in allen drei Raumrichtungen- aus einer Vielzahl von miteinander verbundenen, gegeneinander beweglich angeordneten, in Bezug auf den Strömungsquerschnitt der Transportröhre 16 dimensionsstabilen **Teilgliedern 16'** in Form von für sich jeweils starren, aneinander anschließenden Rohrabschnitten aufgebaut ist.

Die Teilglieder 16' der Transportröhre 16 sind so ausgestaltet, dass auch bei einer axialen Verschiebung oder einer Verkippung unmittelbar benachbarter Teilglieder 16' gegeneinander radial innere Abschnitte der hohlen Teilglieder 16', insbesondere radial innere Kanten, nicht in den lichten Strömungsquerschnitt im Inneren der Transportröhre 16 ragen, durch welchen die NMR-Messproben 14 pneumatisch befördert werden sollen.

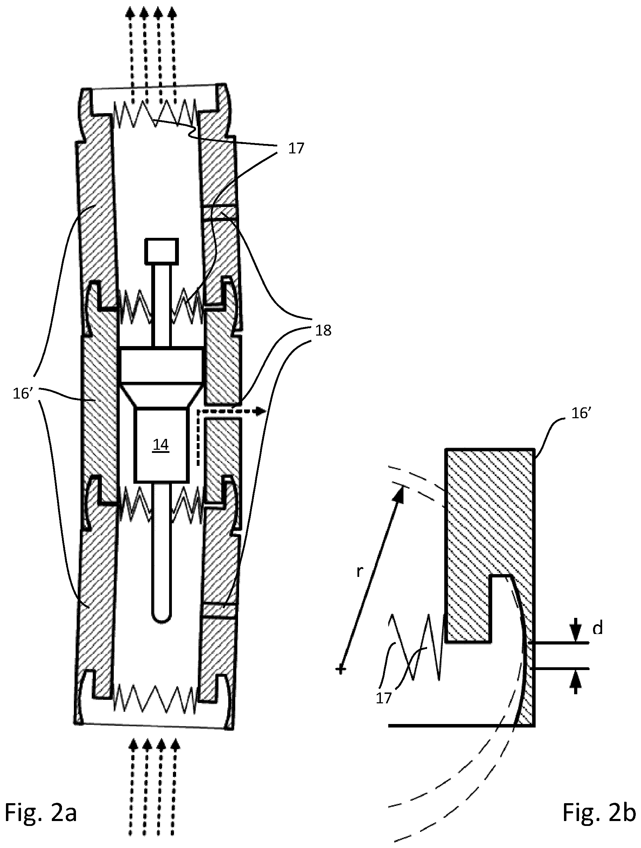

**Fig. 2a** stellt schematisch eine Ausführungsform der erfindungsgemäßen Transporteinrichtung mit -der Übersichtlichkeit wegen lediglich dreizusammengefügten Teilgliedern 16' sowie einer darin durch einen -mit gestrichelten Pfeilen angedeuteten- Gasstrom bewegten NMR-Messprobe 14 dar. In der Realität wird die Transporteinrichtung aber aus wesentlich mehr Teilgliedern 16' aufgebaut sein.

Bevorzugt weisen die Teilglieder 16' der erfindungsgemäßen Transportvorrichtung eine Länge von 20mm bis 100mm auf, besonders bevorzugt etwa 50mm. Der Außendurchmesser liegt vorzugsweise im Bereich zwischen 30mm und 50mm, besonders bevorzugt bei etwa 40mm. Der Innendurchmesser der Teilglieder 16' liegt bevorzugt in einem Bereich von 20mm bis 40mm, besonders bevorzugt bei 26,2mm. Typische NMR-Probenhalter haben einen maximalen Durchmesser von 26mm und gemeinsam mit darin befestigten Probenröhrchen eine Länge von 20,32cm (entspricht 8inch). Die maximale Verkippung der Teilglieder 16' liegt vorzugsweise im Bereich zwischen 0,1° und 5°, besonders bevorzugt bei etwa 0,5°. Beim Einsatz ist die erfindungsgemäße Transportvorrichtung bevorzugt einem dynamischen Druck von 100mbar bis 500mbar ausgesetzt, besonders bevorzugt etwa 300mbar.

Die Teilglieder 16' der Transportröhre 16 weisen an ihrem jeweiligen Endabschnitt, mit dem sie zu einem unmittelbar benachbarten Teilglied 16' anschließen, entweder die Form eines positiven oder eines negativen Kugelgelenksegments auf, wobei das jeweilige positive Kugelgelenksegment passgenau in das negative Kugelgelenksegment des benachbarten Teilglieds 16' derart eingreift, dass die betreffenden beiden Kugelgelenksegmente flächig aneinander anliegen und eine Abdichtfunktion zwischen dem lichten Strömungsquerschnitt der Transportröhre 16 und ihrer Außenseite im Übergangsbereich der beiden Kugelgelenksegmente ausüben.

Zudem weisen die Teilglieder 16' in einem inneren Bereich der Übergänge zwischen benachbarten Teilgliedern 16' eine ineinandergreifende **Zahnstruktur 17** auf, deren eine Außenfläche konisch geformt ist.

Die Transportröhre 16 ist im Bereich der Übergänge zwischen benachbarten Teilgliedern 16' derart ausgestaltet, dass aufgrund der Geometrie der jeweiligen Teilglieder 16' der Grad der möglichen relativen Bewegung zwischen den beiden benachbarten Teilgliedern 16' eingeschränkt ist, sodass ein vorgebbarer minimaler Krümmungsradius der Transportröhre 16 nicht unterschritten werden kann.

Des Weiteren ist die Transportröhre 16 im Bereich der Übergänge zwischen benachbarten Teilgliedern 16' derart ausgestaltet, dass auch Längenausdehnungen in Längsrichtung der Transportröhre 16 kompensiert werden können.

Zumindest einige Teilglieder 16' der Transportröhre 16 weisen verschließbare **radiale Öffnungen 18** auf, durch welche ein kleiner Teil des die NMR-Messprobe 14 bewegenden Gasstromes entweichen kann.

**Fig. 2b** zeigt in vergrößertem Detail das untere Ende eines Teilglieds 16' der Transporteinrichtung von Fig. 2a.

Die Zeichnung verdeutlicht, dass zusätzlich zu den positiven oder negativen Kugelgelenksegmenten an den Endabschnitten der Teilglieder 16', mit denen sie zu unmittelbar benachbarten Teilgliedern 16' anschließen, auch zylindrische Teilflächen vorhanden sein können, die Teil der negativen Kugelgelenksegmente sind. Diese zylindrischen Teilflächen in einer «gestreckten Kugelform » kann man sich beispielsweise durch einen linearen Versatz zweier identischer Kugelflächen mit Radius r um eine Strecke d entstanden vorstellen. Der geometrische Name für eine derartige Gesamtform lautet «Sphärozylinder» oder «Kapsel». Bei der Ausführungsform nach Fig. 2b wäre dies dann also ein «Sphärozylindersegment» oder ein «Kapselsegment», da ja die axialen Enden abgeschnitten sind. Durch diese Ausführung ist gewährleistet, dass benachbarte Teilglieder 16' gegeneinander verkippt werden können und gleichzeitig eine Längenausdehnung stattfinden kann.

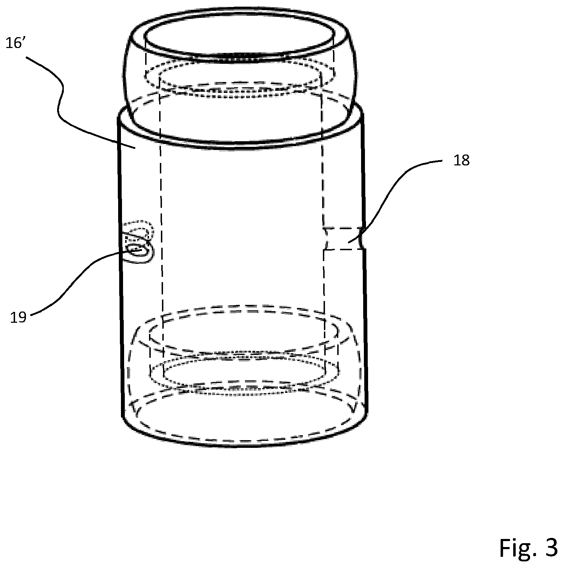

**Fig. 3** zeigt eine Ausführungsform eines einzelnen Teilgliedes 16' der erfindungsgemäßen Transporteinrichtung in einer teil-transparenten schematischen räumlichen Darstellung. Insbesondere erkennt man ein positives Kugelgelenksegment an der Oberseite und ein negatives an der Unterseite des Teilgliedes 16'.

Die Transportröhre 16 und insbesondere einzelne ihrer Teilglieder 16' können **Befestigungselemente 19** zur Befestigung an Teilen des NMR-Spektrometers 10 und/oder zum parallelen Ankoppeln mehrerer Transportröhren 16 aneinander aufweisen.

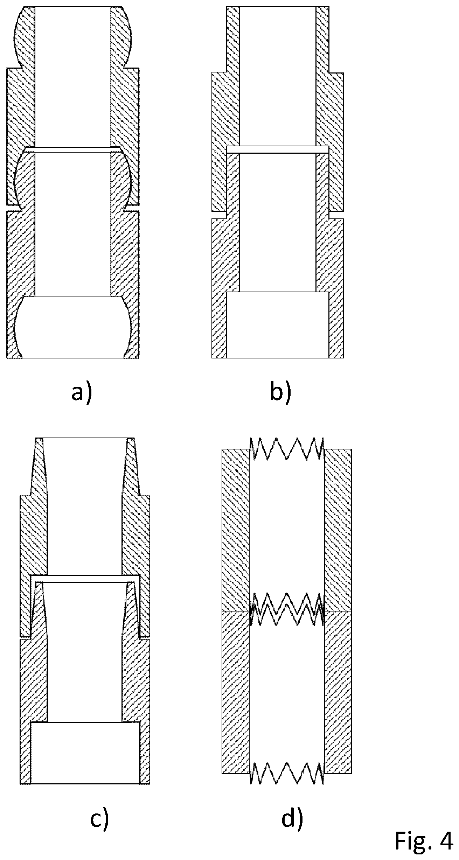

In den **Figuren 4a bis 4d** schließlich soll die prinzipielle Funktionsweise von ineinandergreifenden Kugelgelenksegmenten (Fig. 4a), Zylinderflächen (Fig. 4b), konischen Flächen (Fig. 4c) sowie Verzahnungskränzen (Fig. 4d) im Kopplungsbereich jeweils zweier Teilglieder der erfindungsgemäßen Transportröhre veranschaulicht werden. In der Regel sind bei konkreten Ausführungsformen immer mehrere oder gar sämtliche dieser vier Aspekte verwirklicht. Dies ist jedoch zeichnerisch kaum darstellbar (siehe etwa Fig. 2b). Daher werden die vier Funktionen im Folgenden einzeln erläutert:
**Fig. 4a** **Funktionen: Schnappverschluss, Winkelbewegung und Dichtung**
   Diese Darstellung zeigt das (pure) Kugelgelenk, welches zusammengeschnappt werden kann. Damit dies möglich ist, muss sich das Element im unteren Bereich verformen können. Ein verwendeter Kunststoff muss diese Verformung zulassen ohne dabei Schaden zu nehmen. Sind diese Teile einmal ineinander gesteckt, dann lässt das Kugelgelenk eine Winkelbewegung zu. Bei dieser Winkelbewegung findet dann aber keine Verformung des Materials mehr statt. Weiter dient das Kugelgelenk auch als Abdichtung, damit dort kein Antriebsgas, in der Regel Luft, entweichen kann.
**Fig. 4b** **Funktion: Längenausdehnung**
   Hier wird nur der zylindrische Bereich der Kupplung hervorgehoben. Dieser zylindrische Bereich ermöglicht eine Verschiebung entlang der Achse. Dabei ist ebenfalls zu beachten, dass auch hier durch diese Formgebung kein Antriebsgas aus der zentralen Bohrung entweichen kann.
**Fig. 4c** **Funktion: Winkelbegrenzung**
   Damit der Winkel des Kugelgelenks trotz einer allfälligen Längenausdehnung limitiert werden kann, muss eine Winkelbegrenzung in Form eines Kegels gegenüber eines Zylinders vorhanden sein. Der maximale Winkel zwischen den Elementen ist damit immer gleich, unabhängig von der Längenausdehnung.
**Fig. 4d** **Funktion: Kanten-Aufhebung**
   Damit keine störenden radialen Kanten auf den Innenseiten der Elemente der erfindungsgemäßen Transporteinrichtung auftreten, sind die Übergänge sägezahnförmig verzahnt. Durch diese Verzahnung entsteht ein Winkel zwischen den Übergangskanten zwischen den Elementen und den Kanten am Transportgut. Über die Höhe der Zähne (in der aktuellen Entwicklung ca. 9mm hoch) entstehen so Spalte an der Innenseite und die Verzahnung darf somit nicht höher sein als die Führungslänge des Transportgutes (in Realität ca. 13mm). Wären diese Zähne höher als die Führungslänge des Transportgutes, würde das Antriebsgas durch die entstehenden Spalte am Transportgut vorbeiströmen anstatt dieses voranzutreiben.

Bei -in der vorliegenden Zeichnung nicht eigens dargestellten- weiteren Ausführungsformen der Erfindung kann die Transportröhre 16 Teilglieder 16' unterschiedlicher Länge und/oder unterschiedlicher Bewegungsfreiheit enthalten. In der Regel werden aber zumindest einige der Teilglieder 16' der Transportröhre 16 baugleich gestaltet sein.

Die Teilglieder 16' der Transportröhre 16 werden so gestaltet sein, dass die Transportröhre 16 ohne Werkzeug wiederholbar zerlegt und wieder zusammengesetzt werden kann, insbesondere zum Transport, zur Wartung, Reparatur und Reinigung und/oder zur Längenanpassung der Transportröhre 16.

Zumindest einige Teilglieder 16' der Transportröhre 16 können ganz oder teilweise aus optisch transparentem Material aufgebaut sein, so dass man von außen sehen kann, wo sich eine NMR-Messprobe befindet.

Außerdem sollte die Transportröhre 16 aus elektrisch leitfähigem Material aufgebaut oder mit einem solchen beschichtet sein. Hierdurch wird eine elektrostatische Aufladung der Transportvorrichtung verhindert, zumindest vermindert.

Bei wiederum in der Zeichnung nicht dargestellten Ausführungsformen schließlich können zumindest einige Teilglieder 16' der Transportröhre 16 als Schlauchabschnitte, vorzugsweise mit interner und/oder externer Stützstruktur, ausgeführt sein.

### Bezugszeichenliste:

- 10: NMR- Spektrometer
- 11: NMR-Magnetsystem
- 12: Einrichtung zur Vibrations-Entkoppelung
- 13: Proben-Speicher
- 14: NMR-Messprobe
- 15: Messvolumen
- 16: Transportröhre
- 16': Teilglieder
- 17: Zahnstruktur
- 18: radiale Öffnungen
- 19: Befestigungselemente

### Referenzliste:

Für die Beurteilung der Patentfähigkeit in Betracht gezogene Publikationen:
[0] US 5 150 054 A
[1] US 8,217,655 B2 ≈ DE 10 2008 063 703 B3 ≈ EP 2 199 816 B1 ≈ ≈ JP 5330983 B2
[2] US 10,782,369 B2 ≈ DE 10 2018 205 535 B3 ≈ EP 3 553 545 B1
[3] DE 37 29 819 C2
[4] Firmenbroschüre Z31123"Bruker Sample Transport. BST Installation and Technical Manual Version 002" der Bruker BioSpin AG vom 21. November 2008
[5] US 9,726,735 B2 ≈ DE 10 2013 212 312 B4 ≈ UK 2520375 B ≈ JP 6425429 B2 ≈ CN 104251981 B ≈ CH 708 241 B1
[6] US 9,903,923 B2 ≈ DE 10 2014 201 076 B3 ≈ UK 2523007 B ≈ JP 6033343 B2 ≈ CN 104793157 B ≈ CH 709 198 B1
[7] US 11,073,583 B2 ≈ EP 3 715 893 B1 ≈ CN 111736103 B
[8] JP 2006-234539 A
[9] US 11,231,471 B2
[10] US 2015/0198681 A1
[11] US 2024/0069129 A1

## Patentansprüche

1. Transporteinrichtung mit einer gasabgedichteten durchgehend bidirektional betreibbaren Transportröhre (16) zur pneumatischen Beförderung von NMR-Messproben (14) aus einem Proben-Speicher (13) in ein Messvolumen (15) innerhalb des NMR-Magnetsystems (11) eines NMR-Spektrometers (10),
**dadurch gekennzeichnet,**
**dass** die Transportröhre (16) trotz Gasabdichtung mechanisch flexibel aus einer Vielzahl von miteinander verbundenen, gegeneinander beweglich angeordneten, in Bezug auf den Strömungsquerschnitt der Transportröhre (16) dimensionsstabilen Teilgliedern (16') in Form von für sich jeweils starren Rohrabschnitten aufgebaut ist, derart, dass auch bei einer axialen Verschiebung oder einer Verkippung unmittelbar benachbarter Teilglieder (16') gegeneinander radial innere Abschnitte der hohlen Teilglieder (16'), insbesondere radial innere Kanten, nicht in den lichten Strömungsquerschnitt im Inneren der Transportröhre (16) ragen, durch welchen die NMR-Messproben (14) pneumatisch befördert werden sollen.

2. NMR-Spektrometer (10) mit einem NMR-Magnetsystem (11), das auf einer Einrichtung (12) zur Vibrations-Entkoppelung des NMR-Magnetsystems von der Umgebung aufgebaut ist, mit einem Proben-Speicher (13) zur Bereitstellung und Zwischenlagerung von zu vermessenden NMR-Messproben (14) sowie mit einer Transporteinrichtung nach Anspruch 1 zur Beförderung jeweils einer NMR- Messprobe (14) aus dem Proben-Speicher (13) in ein Messvolumen (15) innerhalb des NMR-Magnetsystems (11).

3. Transporteinrichtung nach Anspruch 1, **dadurch gekennzeichnet, dass** die Teilglieder (16') der Transportröhre (16) an ihrem jeweiligen Endabschnitt, mit dem sie zu einem unmittelbar benachbarten Teilglied (16') anschließen, entweder die Form eines positiven oder eines negativen Kugelgelenksegments aufweisen, wobei das jeweilige positive Kugelgelenksegment passgenau in das negative Kugelgelenksegment des benachbarten Teilglieds (16') derart eingreift, dass die betreffenden beiden Kugelgelenksegmente flächig aneinander anliegen und eine Abdichtfunktion zwischen dem lichten Strömungsquerschnitt der Transportröhre (16) und ihrer Außenseite im Übergangsbereich der beiden Kugelgelenksegmente ausüben.

4. Transporteinrichtung nach Anspruch 3, **dadurch gekennzeichnet, dass** zusätzlich zu den positiven oder negativen Kugelgelenksegmenten an den Endabschnitten der Teilglieder (16'), mit denen sie zu unmittelbar benachbarten Teilgliedern (16') anschließen, auch zylindrische Teilflächen vorhanden sind, die vorzugsweise Teil der Kugelgelenksegmente, insbesondere der negativen, sind.

5. Transporteinrichtung nach einem der Ansprüche 1, 3 oder 4, **dadurch gekennzeichnet, dass** die Teilglieder (16') in einem inneren Bereich der Übergänge zwischen benachbarten Teilgliedern (16') eine ineinander greifende Zahnstruktur (17) aufweisen, deren eine Außenfläche konisch geformt ist.

6. Transporteinrichtung nach Anspruch 1 oder einem der Ansprüche 3-5, **dadurch gekennzeichnet, dass** die Transportröhre (16) im Bereich der Übergänge zwischen benachbarten Teilgliedern (16') derart ausgestaltet ist, dass aufgrund der Geometrie der jeweiligen Teilglieder (16') der Grad der möglichen relativen Bewegung zwischen den beiden benachbarten Teilgliedern (16') eingeschränkt ist, sodass ein vorgebbarer minimaler Krümmungsradius der Transportröhre (16) nicht unterschritten werden kann, wobei insbesondere die maximale Verkippung der Teilglieder (16') zwischen 0,1° und 5°, besonders bevorzugt bei 0,5° liegt.

7. Transporteinrichtung nach Anspruch 1 oder einem der Ansprüche 3-6, **dadurch gekennzeichnet, dass** die Transportröhre (16) im Bereich der Übergänge zwischen benachbarten Teilgliedern (16') durch eine zylindrische Kupplung mit eineinandergreifenden Zylinderflächen, welche eine axiale Verschiebung ermöglicht, derart ausgestaltet ist, dass auch Längenausdehnungen in Längsrichtung der Transportröhre (16) kompensiert werden können.

8. Transporteinrichtung nach Anspruch 1 oder einem der Ansprüche 3-7, **dadurch gekennzeichnet, dass** zumindest einige der Teilglieder (16') der Transportröhre (16) baugleich gestaltet sind.

9. Transporteinrichtung nach Anspruch 1 oder einem der Ansprüche 3-8, **dadurch gekennzeichnet, dass** die Transportröhre (16) Teilglieder (16') unterschiedlicher Länge und/oder unterschiedlicher Bewegungsfreiheit enthält.

10. Transporteinrichtung nach Anspruch 1 oder einem der Ansprüche 3-9, **dadurch gekennzeichnet, dass** die Teilgliedern (16') der Transportröhre (16) so gestaltet sind, dass die Transportröhre (16) ohne Werkzeug wiederholbar zerlegt und wieder zusammengesetzt werden kann, insbesondere zum Transport, zur Wartung, Reparatur und Reinigung und/oder zur Längenanpassung der Transportröhre (16).

11. Transporteinrichtung nach Anspruch 1 oder einer der Ansprüche 3-10, **dadurch gekennzeichnet, dass** zumindest einige Teilglieder (16') der Transportröhre (16) verschließbare radiale Öffnungen (18) aufweisen.

12. Transporteinrichtung nach Anspruch 1 oder einem der Ansprüche 3-11, gekennzeichnet, dass zumindest einige Teilglieder (16') der Transportröhre (16) ganz oder teilweise aus optisch transparentem Material aufgebaut sind.

13. Transporteinrichtung nach Anspruch 1 oder einem der Ansprüche 3-12, **dadurch gekennzeichnet, dass** die Transportröhre (16) ganz oder teilweise aus elektrisch leitfähigem Material aufgebaut oder mit einem solchen beschichtet ist.

14. Transporteinrichtung nach Anspruch 1 oder einem der Ansprüche 3-13, **dadurch gekennzeichnet, dass** zumindest einige Teilglieder (16') der Transportröhre (16) als Schlauchabschnitte, vorzugsweise mit interner und/oder externer Stützstruktur, ausgeführt sind.

15. Transporteinrichtung nach Anspruch 1 oder einem der Ansprüche 3-14, **dadurch gekennzeichnet, dass** die Transportröhre (16) Befestigungselemente (19) zur Befestigung an Teilen des NMR-Spektrometers (10) und/oder zum parallelen Ankoppeln mehrerer Transportröhren (16) aneinander aufweist.

## Claims

1. A transport device comprising a gastight sealed, pneumatically throughout bidirectionally operable transport tube (16) for the pneumatic transport of NMR measurement samples (14) from a sample storage means (13) into a measurement volume (15) within the NMR magnet system (11) of an NMR spectrometer (10),
**characterized in that**
the transport tube (16), despite being sealed in a gastight manner, is composed of a plurality of sub-members (16') constructed in a mechanically flexible way, the sub-members (16') in the shape of pipe sections being rigid in each case and arranged movable relative to one another and are dimensionally stable with respect to the flow cross-section of the transport tube (16), in such a manner that the sub-members (16') of the transport tube (16) are designed such that even in the event of any axial displacement or tilting of immediately adjacent sub-members (16') relative to one another, radially inner portions of the hollow sub-members (16'), in particular radially inner edges, do not project into the clear flow cross-section in the interior of the transport tube (16) through which the NMR measurement samples (14) are to be pneumatically transported.

2. An NMR spectrometer (10) comprising an NMR magnet system (11), which is mounted on a device (12) for isolating the vibrations of the NMR magnet system from the environment, comprising a sample storage means (13) for providing and temporarily storing NMR measurement samples (14) to be measured, and comprising a transport device according to claim 1 for transporting in each case one NMR measurement sample (14) from the sample storage means (13) into a measurement volume (15) within the NMR magnet system (11).

3. The transport device according to claim 1, **characterized in that** each of the sub-members (16') of the transport tube (16) have, in their end portion with which they connect to an immediately adjacent sub-member (16'), either the shape of a positive or a negative ball joint segment, the positive ball joint segment precisely engaging in the negative ball joint segment of the adjacent sub-member (16') each time such that the two ball joint segments in question abut one another surface-to-surface and exert a sealing function between the clear flow cross-section of the transport tube (16) and its outer side in the transition region of the two ball joint segments.

4. The transport device according to claim 3, **characterized in that**, in addition to the positive or negative ball joint segments in the end portions of the sub-members (16'), with which they connect to immediately adjacent sub-members (16'), there are also cylindrical partial surfaces which are preferably part of the ball joint segments, in particular of the negative ball joint segments.

5. The transport device according to any one of the claims 1, 3 or 4, **characterized in that** the sub-members (16') have, in an inner region of the transition points between adjacent sub-members (16'), a meshing toothed structure (17), an outer surface of which is conical.

6. The transport device according to claim 1 or any one of the claims 3 to 5, **characterized in that** the transport tube (16) is designed in the region of the transition points between adjacent sub-members (16') such that, due to the geometry of each sub-member (16'), the degree of relative movement possible between the two adjacent sub-members (16') is limited so that it is not possible to fall below a predeterminable minimum radius of curvature of the transport tube (16), in particular the maximum degree of tilting of the sub-members (16') in particular being between 0.1° and 5°, particularly preferably being 0.5°.

7. The transport device according to claim 1 or any one of the claims 3 to 6, **characterized in that** the transport tube (16) is designed in the region of the transition points between adjacent sub-members (16') by means of a cylindrical coupling with intermeshing cylindrical surfaces enabling an axial displacement in such a way that linear extensions in the longitudinal direction of the transport tube (16) can also be compensated for.

8. The transport device according to claim 1 or any one of the claims 3 to 7, **characterized in that** at least some of the sub-members (16') of the transport tube (16) are identically constructed.

9. The transport device according to claim 1 or any one of the claims 3 to 8, **characterized in that** the transport tube (16) contains sub-members (16') whose length and/or freedom of movement differ(s).

10. The transport device according to claim 1 or any one of the claims 3 to 9, **characterized in that** the sub-members (16') of the transport tube (16) are designed such that the transport tube (16) can be repeatedly disassembled and reassembled without tools, in particular for transport, maintenance, repair and cleaning and/or for adjusting the length of the transport tube (16).

11. The transport device according to claim 1 or any one of the claims 3 to 10, **characterized in that** at least some sub-members (16') of the transport tube (16) have closable radial openings (18).

12. The transport device according to claim 1 or any one of the claims 3 to 11, **characterized in that** at least some sub-members (16') of the transport tube (16) are constructed entirely or partially from optically transparent material.

13. The transport device according to claim 1 or any one of the claims 3 to 12, **characterized in that** the transport tube (16) is constructed entirely or partially from electrically conductive material or is coated with such a material.

14. The transport device according to claim 1 or any one of the claims 3 to 13, **characterized in that** at least some sub-members (16') of the transport tube (16) are designed as hose sections, preferably with internal an and/or external support structure.

15. The transport device according to claim 1 or any one of the claims 3 to 14, **characterized in that** the transport tube (16) comprises fastening elements (19) for fastening it to parts of the NMR spectrometer (10) and/or for coupling a plurality of transport tubes (16) to one another at the same time.

## Revendications

1. Dispositif de transport comprenant un tube de transport (16) étanche aux gaz, scellé et pouvant fonctionner de manière bidirectionnelle par voie pneumatique, destiné au transport pneumatique d'échantillons de mesure RMN (14) depuis un moyen de stockage d'échantillons (13) vers un volume de mesure (15) à l'intérieur du système magnétique RMN (11) d'un spectromètre RMN (10),
**caractérisé en ce que**
le tube de transport (16), bien qu'étanche aux gaz, est composé d'une pluralité d'éléments partiels (16') construits de manière mécaniquement flexible, les éléments partiels (16') en forme de sections de tuyau étant chacun rigides et disposés de manière à pouvoir se déplacer les uns par rapport aux autres, et sont dimensionnellement stables par rapport à la section d'écoulement du tube de transport (16), de telle sorte que les éléments partiels (16') du tube de transport (16) sont conçus de manière à ce que, même en cas de déplacement axial ou de basculement d'éléments partiels (16') immédiatement adjacents les uns par rapport aux autres, les parties radialement intérieures des éléments partiels creux (16'), en particulier les bords radialement intérieurs, ne font pas saillie dans la section transversale d'écoulement libre à l'intérieur du tube de transport (16) à travers lequel les échantillons de mesure RMN (14) doivent être transportés pneumatiquement.

2. Spectromètre RMN (10) comprenant un système d'aimant RMN (11), qui est monté sur un dispositif (12) destiné à isoler les vibrations du système d'aimant RMN de l'environnement, comprenant un moyen de stockage d'échantillons (13) destiné à fournir et à stocker temporairement des échantillons de mesure RMN (14) à mesurer, et comprenant un dispositif de transport selon la revendication 1 destiné à transporter à chaque fois un échantillon de mesure RMN (14) depuis le moyen de stockage d'échantillons (13) vers un volume de mesure (15) à l'intérieur du système d'aimant RMN (11).

3. Dispositif de transport selon la revendication 1, **caractérisé en ce que** chacun des éléments partiels (16') du tube de transport (16) présente, dans sa partie d'extrémité par laquelle il se raccorde à un élément partiel (16') immédiatement adjacent, soit la forme d'un segment de joint à rotule positif, soit celle d'un segment de joint à rotule négatif, le segment de joint à rotule positif s'engageant chaque fois avec précision dans le segment de joint à rotule négatif de l'élément partiel adjacent (16'), de telle sorte que les deux segments de joint à rotule en question s'appuient l'un contre l'autre par leurs surfaces et exercent une fonction d'étanchéité entre la section d'écoulement libre du tube de transport (16) et sa face extérieure dans la zone de transition des deux segments de joint à rotule.

4. Dispositif de transport selon la revendication 3, **caractérisé en ce que**, outre les segments de joint à rotule mâle ou femelle situés dans les parties d'extrémité des éléments partiels (16'), par lesquels ceux-ci se raccordent aux éléments partiels (16') immédiatement adjacents, il existe également des surfaces partielles cylindriques qui font de préférence partie des segments de joint à rotule, en particulier des segments de joint à rotule femelle.

5. Dispositif de transport selon l'une quelconque des revendications 1, 3 ou 4, **caractérisé en ce que** les éléments secondaires (16') présentent, dans une région intérieure des points de transition entre des éléments secondaires adjacents (16'), une structure dentée s'engrenant (17) dont une surface extérieure est conique.

6. Dispositif de transport selon la revendication 1 ou l'une quelconque des revendications 3 à 5, **caractérisé en ce que** le tube de transport (16) est conçu, dans la zone des points de transition entre des éléments partiels adjacents (16'), de telle sorte que, en raison de la géométrie de chaque élément partiel (16'), le degré de mouvement relatif possible entre les deux éléments partiels adjacents (16') est limité de telle sorte qu'il n'est pas possible, en principe, de descendre en dessous d'un rayon de courbure minimal prédéterminable du tube de transport (16), l'angle d'inclinaison maximal des éléments partiels (16') se situant notamment entre 0,1° et 5°, de préférence 0,5°.

7. Dispositif de transport selon la revendication 1 ou l'une quelconque des revendications 3 à 6, **caractérisé en ce que** le tube de transport (16) est conçu, dans la zone des points de transition entre des éléments partiels adjacents (16'), au moyen d'un raccord cylindrique à surfaces cylindriques en prise permettant un déplacement axial, de telle sorte que les allongements linéaires dans la direction longitudinale du tube de transport (16) puissent également être compensés.

8. Dispositif de transport selon la revendication 1 ou l'une quelconque des revendications 3 à 7, **caractérisé en ce qu'**au moins certains des éléments partiels (16') du tube de transport (16) sont de construction identique.

9. Dispositif de transport selon la revendication 1 ou l'une quelconque des revendications 3 à 8, **caractérisé en ce que** le tube de transport (16) contient des éléments partiels (16') dont la longueur et/ou la liberté de mouvement diffèrent.

10. Dispositif de transport selon la revendication 1 ou l'une quelconque des revendications 3 à 9, **caractérisé en ce que** les éléments partiels (16') du tube de transport (16) sont conçus de telle sorte que le tube de transport (16) puisse être démonté et remonté à plusieurs reprises sans outils, en particulier pour le transport, l'entretien, la réparation et le nettoyage et/ou pour ajuster la longueur du tube de transport (16).

11. Dispositif de transport selon la revendication 1 ou l'une quelconque des revendications 3 à 10, **caractérisé en ce qu'**au moins certains éléments partiels (16') du tube de transport (16) présentent des ouvertures radiales (18) pouvant être fermées.

12. Dispositif de transport selon la revendication 1 ou l'une quelconque des revendications 3 à 11, **caractérisé en ce qu'**au moins certains éléments partiels (16') du tube de transport (16) sont constitués entièrement ou partiellement d'un matériau optiquement transparent.

13. Dispositif de transport selon la revendication 1 ou l'une quelconque des revendications 3 à 12, **caractérisé en ce que** le tube de transport (16) est constitué entièrement ou partiellement d'un matériau électriquement conducteur ou est recouvert d'un tel matériau.

14. Dispositif de transport selon la revendication 1 ou l'une quelconque des revendications 3 à 13, **caractérisé en ce qu'**au moins certains éléments partiels (16') du tube de transport (16) sont conçus sous forme de sections de tuyau, de préférence avec une structure de support interne et/ou externe.

15. Dispositif de transport selon la revendication 1 ou l'une quelconque des revendications 3 à 14, **caractérisé en ce que** le tube de transport (16) comprend des éléments de fixation (19) destinés à le fixer à des parties du spectromètre RMN (10) et/ou à coupler simultanément plusieurs tubes de transport (16) les uns aux autres.
